# EUROPEAN PATENT APPLICATION

(11) **EP 4 797 891 A1**
(43) Date of publication of application: **26.08.2026**
(21) Application number: 26159757.9
(22) Date of filing: 20.02.2026
(51) Int. Cl.: H05K 7/14

(54) **FLOATING BUSBAR FOR A POWER DISTRIBUTION UNIT**

(30) Priority: 21.02.2025 US 202563761270 P; 06.02.2026 US 202619531757
(71) Applicant: Vertiv Corporation, Westerville, OH 43082 (US)
(72) Inventor: ESBER, Patrick G., Westerville, 43082 (US)
(74) Representative: Beal, James Michael

(57) **Abstract**

A power distribution unit includes: a backplane with backplane slots; a primary busbar having a least one primary faster hole on one end for fastening the primary busbar to the backplane; and a primary mounting plain extending perpendicularly from an opposing end with at least one primary slot therethrough. The power distribution unit further includes a central busbar having a central mounting plain extending perpendicularly from one end, mounted to the primary mounting plain, and a central slot therethrough on an opposing end. The power distribution unit also includes an ancillary busbar mounted to the central busbar around the central slot.

## Description

### CROSS-REFERENCE TO RELATED APPLICATIONS

This Application claims priority to U.S. Provisional Patent Application No. 63/761,270, filed February 21, 2025, and to U.S. Non-Provisional Patent Application No. 19/531,757, filed February 6, 2026.

### FIELD

The present disclosure relates generally to computer and/or telecommunications equipment cabinets, such as might be found in a data center, and more specifically to power distribution systems within such equipment cabinets.

### BACKGROUND

High-power copper busbars are commonly used in electrical power distribution systems to carry large currents and efficiently transfer electrical energy. One predominant method to connect to such busbars is to utilize bolted connections. The busbars are drilled to create holes at specific intervals, and bolts, nuts, and washers are used to fasten them together. Bolted connections offer good mechanical strength and can manage high currents.

Bolted bridge bars are also often used to connect to such busbars. Bridge bars are short sections of busbars that are used to bridge the gap between two busbars. They are typically bolted or welded onto the adjacent busbars, creating a continuous electrical path. Proper alignment and appropriate hardware are important to ensure reliable connections with both direct bolted connections as well as connections utilizing bridge bars.

Several factors contribute to the misalignment of a busbar and difficulties in joining busbars together. The most predominate factor being tolerance stacking, which causes predesigned busbars to not align as designed. Additionally, a predesigned busbar does not enable various changes in the design or connection changes. The traditional solution is to run thick wires or cables which are more flexible than busbars and alleviate any concern of tolerance stacking. Although cables enable flexibility in design and changes to the connections, they are electrically insolated which prevents them from cooling as efficiently as a coper busbar. Additionally, cable routing and position is not constant between one cable and another when compared to a solid copper busbar.

### SUMMARY

An aspect of the disclose embodiments includes a power distribution unit. The power distribution unit includes: a backplane with backplane slots; a primary busbar having a least one primary faster hole on one end for fastening the primary busbar to the backplane; and a primary mounting plain extending perpendicularly from an opposing end with at least one primary slot therethrough. The power distribution unit further includes a central busbar having a central mounting plain extending perpendicularly from one end, mounted to the primary mounting plain, and a central slot therethrough on an opposing end. The power distribution unit also includes an ancillary busbar mounted to the central busbar around the central slot.

Another aspect of the disclosed embodiments includes a system for power distribution. The system includes: a backplane having at least one backplane slot; a primary busbar mounted to the backplane and having a primary mounting plain extending perpendicularly with at least one slot, wherein the primary busbar includes a first floating busbar; a central busbar having at least one central slot and a central mounting plain extending perpendicularly with a hole, wherein the central busbar includes a second floating busbar; and an ancillary busbar mounted to the central busbar via the central slot and physically and electrically connected to a power providing unit.

### BRIEF DESCRIPTION OF THE DRAWINGS

The disclosure is best understood from the following detailed description when read in conjunction with the accompanying drawings. It is emphasized that, according to common practice, the various features of the drawings are not to-scale. On the contrary, the dimensions of the various features are arbitrarily expanded or reduced for clarity.
FIG. 1 is an illustration that represents an embodiment of the primary busbar of the power distribution unit of the present disclosure.
FIG. 2 illustrates an embodiment of the central busbar of the power distribution unit of the present disclosure.
FIG. 3 illustrates an embodiment of the ancillary busbar of the power distribution unit of the present disclosure.
FIG. 4 illustrates an embodiment of the power distribution unit of the present invention physically and electrically mounted to a power providing unit and a backplane to represent the floating aspect of the present disclosure.

Those skilled in the art will appreciate and understand that, according to common practice, various features of the drawings discussed below are not necessarily drawn to scale, and that dimensions of various features and elements of the drawings may be expanded or reduced to more clearly illustrate the embodiments of the present disclosure described herein.

### DETAILED DESCRIPTION

The following discussion is directed to various embodiments of the disclosure. Although one or more of these embodiments may be preferred, the embodiments disclosed should not be interpreted, or otherwise used, as limiting the scope of the disclosure, including the claims. In addition, one skilled in the art will understand that the following description has broad application, and the discussion of any embodiment is meant only to be exemplary of that embodiment, and not intended to intimate that the scope of the disclosure, including the claims, is limited to that embodiment.

The present specification and accompanying drawings disclose one or more embodiments that incorporate the features of the present disclosure. The scope of the present disclosure is not limited to the disclosed embodiments. The disclosed embodiments merely exemplify the present disclosure, and modified versions of the disclosed embodiments are also encompassed by the present disclosure. Embodiments of the present disclosure are defined by the claims appended hereto.

References in the specification to "one embodiment," "an embodiment," "an example embodiment," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to effect such feature, structure, or characteristic in connection with other embodiments whether or not explicitly described.

In the discussion, unless otherwise stated, adjectives such as "substantially," "approximately," and "about" modifying a condition or relationship characteristic of a feature or features of an embodiment of the disclosure, are understood to mean that the condition or characteristic is defined to be within tolerances that are acceptable for operation of the embodiment for an application for which it is intended.

Furthermore, it should be understood that spatial descriptions (e.g., "above," "below," "up," "left," "right," "down," "top," "bottom," "vertical," "horizontal," etc.) used herein are for purposes of illustration only, and that practical implementations of the structures described herein can be spatially arranged in any orientation or manner.

The word "example" is used herein to mean serving as an example, instance, or illustration. Any aspect or design described herein as "example" is not necessarily to be construed as preferred or advantageous over other aspects or designs. Rather, use of the word "example" is intended to present concepts in a concrete fashion. As used in this application, the term "or" is intended to mean an inclusive "or" rather than an exclusive "or." That is, unless specified otherwise, or clear from context, "X includes A or B" is intended to mean any of the natural inclusive permutations. That is, if X includes A; X includes B; or X includes both A and B, then "X includes A or B" is satisfied under any of the foregoing instances. In addition, the articles "a" and "an" as used in this application and the appended claims should generally be construed to mean "one or more" unless specified otherwise or clear from context to be directed to a singular form. Moreover, use of the term "an implementation" or "one implementation" throughout is not intended to mean the same embodiment or implementation unless described as such.

Numerous exemplary embodiments are described as follows. It is noted that any section/subsection headings provided herein are not intended to be limiting. Embodiments are described throughout this document, and any type of embodiment may be included under any section/subsection. Furthermore, embodiments disclosed in any section/subsection may be combined with any other embodiments described in the same section/subsection and/or a different section/subsection in any manner.

The systems and methods described herein may be directed to addressing a need in the market for a power transition that incorporates the flexibility of cables and the thermal and reparability of a copper busbar.

The system and methods described herein may be configured to provide a power distribution unit that utilizes a slot design and consists of a series of busbars, that can be mounted within an enclosure, distribute power, and whereby the power distribution unit can float or move in the vertical, horizontal and depth axis in relation to their fixed mounting points of a backplane and a power providing unit (i.e. a transformer) until fixed by fasteners.

The system and methods described herein may be configured to provide a power distribution unit consisting of a series of busbars which may be made from conductive material such as copper, brass, or aluminum. The series of busbars include a primary busbar, a central busbar, and an ancillary busbar which together along with a backplane, remove the issues related to tolerance stacking by utilizing slots.

The power distribution unit may include: a backplane with backplane slots; a primary busbar having a least one primary faster hole on one end for fastening the primary busbar to the backplane; and a primary mounting plain extending perpendicularly from an opposing end with at least one primary slot therethrough. The power distribution unit may also include a central busbar having a central mounting plain extending perpendicularly from one end, mounted to the primary mounting plain, and a central slot therethrough on an opposing end. The power distribution unit may also include an ancillary busbar mounted to the central busbar around the central slot. As used herein, the primary mounting plain may be referred to as a primary mounting plane. As used herein, the central mounting plain may be referred to as a central mounting plane.

The primary busbar may include additional primary fastener holes therethrough, to facilitate fasteners for mounting the primary busbar to a back plane, standoff insulators that provide electrical isolation between the primary busbar and the backplane, and additional primary slots therethrough for additional fasteners.

The central busbar may include central holes therethrough the central mounting plain. The central holes facilitate fasteners such that when mounted to the primary busbar, fasteners can be inserted through the central holes of the central mounting plain, through the primary slots of the primary mounting plain of the primary busbar, thereby fixing the central mounting plain to the primary mounting plain and enjoining both physically and electrically the central busbar to the primary busbar.

The ancillary busbar include ancillary holes therethrough one end of the ancillary busbar to facilitate fasteners. When the ancillary busbar is mounted to the central busbar, fasteners can be inserted through the ancillary holes of the ancillary busbar, through the central slots of the central busbar, thereby fixing the ancillary busbar to the central busbar enjoining the ancillary busbar to the central busbar both physically and electrically.

In some embodiments, the use of slots in disposed in relation to holes for fasteners enables the power distribution unit to move or float along at last one of a vertical axis, a horizontal axis, and a depth axis until fixed by fasteners. This ability to float before fixing eliminates any misalignment issues associated with tolerance stacking without the need for an insulated flexible cable.

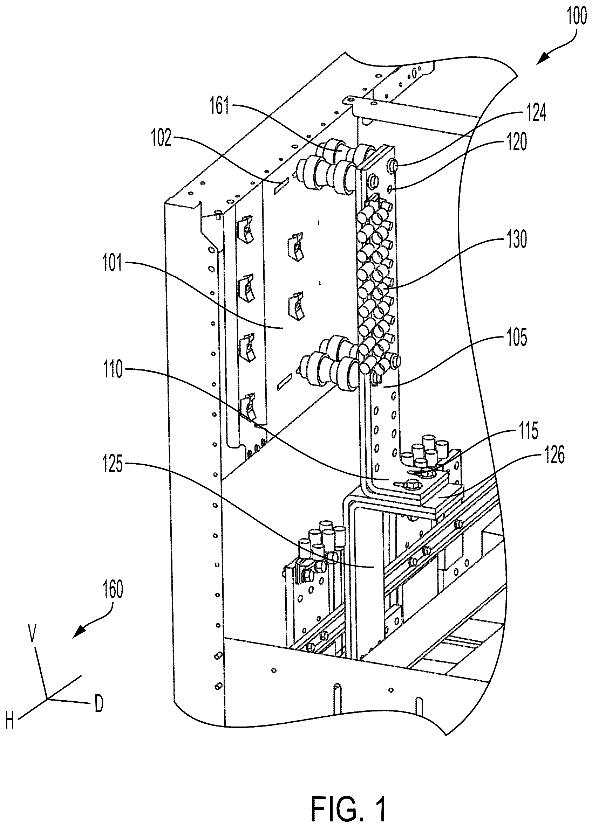

As is generally illustrated in FIG. 1, a primary busbar 105, of a power distribution unit 100, is mounted to a backplane 101 and can be fixed or secured by fasteners 124 that extend through a primary fastener hole 120, provided on one end of the primary busbar 105, through a standoff isolator 161, and through a backplane slot 102 such that the primary busbar 105 is physically mounted to the backplane 101. As further represented, the backplane slot 102 may be oval in shape, and may extend horizontally in relation to the backplane 101. This horizontal oval backplane slot 102 enables the horizontal movement in the horizontal axis as shown by the representation of the letter H in the scale 160 as the primary busbar 105 is mounted to the backplane 101, and further fixed by fasteners 124. Although only singularly described herein additional fasteners, faster holes, standoff isolators, and slots are represented and in use provide physical strength to the power distribution unit 100.

The primary busbar also includes a primary mounting plain 110, which resides on the opposing end in relation to the primary fastener hole 120 and extends perpendicularly out from the primary busbar 105 and includes at least one primary slot 115 therethrough the primary mounting plain 110. The primary slot 115 may be oval in shape and may extend inwardly in relation to the primary busbar 105. Additionally, or alternatively, power receptacles 130 may be mounted to the primary busbar 105 and may allow for additional power connections (not shown) to electrically connect to the primary busbar 105.

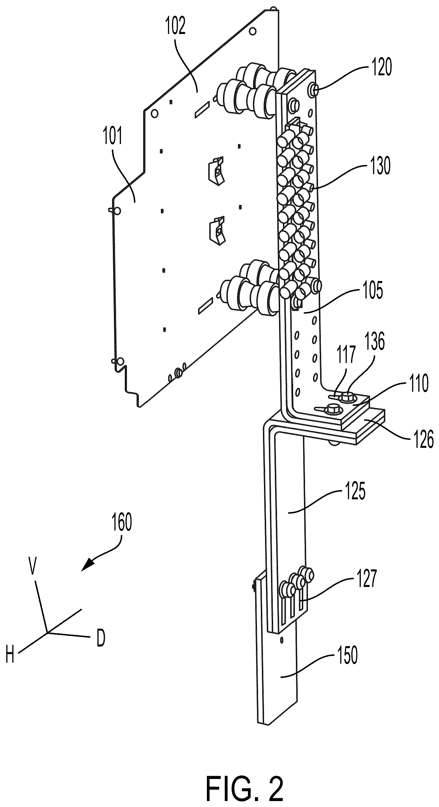

One end of a central busbar 125 as represented in FIG. 2, consists of a central mounting plain 126 which extends perpendicularly from the central busbar 125 with at least one central fastening hole (not shown) therethrough. As shown, the central busbar 125 is mounted to the primary busbar 105 by way of fixing the central mounting plain 126 to the primary mounting plain 110 by a fastener 124. The oval shape of the at least one primary slot 117 provides for movement in the depth axis as presented by the letter D in the scale 160 when mounting the central mounting plain 126 to the primary mounting plain 110 by inserting a fastener 136 through the central fastening hole (not shown), through the primary slot 117 whereby the primary slot 117 provides movement of the central busbar 125 in relation to the primary busbar 105 in the D axis until further fixed by a fastener. The opposing end of the central busbar 125 consists of at least one central slot 127 therethrough, which is oval in shape, and extends vertically in relation to the central busbar 125 and the ancillary busbar 150.

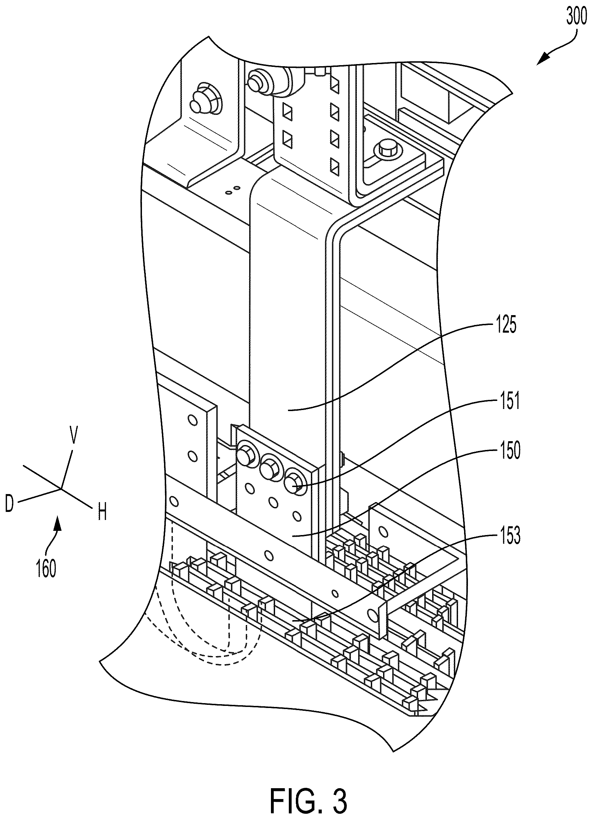

As it relates to FIG. 3 and which represents an embodiment of the ancillary busbar 150 with ancillary holes (not shown) for the ancillary fastener 151 on one end and is physically and electrically connected to a power providing unit 153, a transformer, on the other end. Together FIG. 2 and FIG. 3 represent the mounting of the ancillary busbar 150 and the central busbar 125. More specifically as mounted, the ancillary fasteners 151 extend through the ancillary holes in the ancillary busbar 150 and through the central slots 127. The oval shape of the central slot 127, provides for movement in the vertical axis V as represented in the scale 160 when mounting the ancillary busbar 150 to the central busbar 125, which can be fixed by an ancillary faster 151.

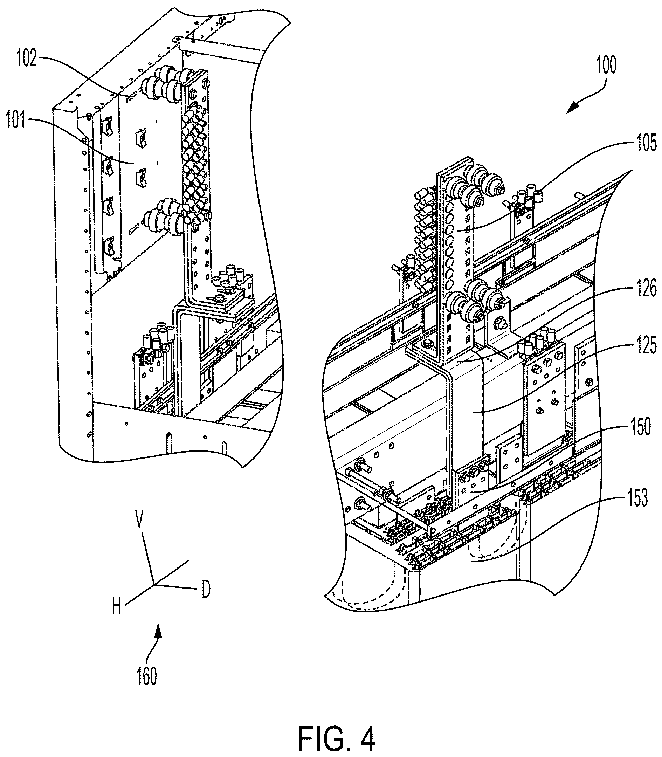

Two figures are depicted in FIG. 4, which together represent the floating power distribution unit 100 until fixed by fasteners. More specifically, the backplane slot 102, the primary slot 115, and the central slot 127 provide the power distribution unit 100 with the ability to float between the backplane 101 and the power providing unit 153 in the vertical, horizontal, and depth axis until fixed with fasteners. The ability to float before fixing by fasteners alleviates the issue relating to tolerance stack by providing play or movement by way of the series of busbars in the vertical, horizontal, and depth directions shown in the scale 160.

In some embodiments, a power distribution unit includes: a backplane having at least one backplane slot; a primary busbar mounted to the backplane, having a least one primary fastener hole on one end and a primary mounting plain extending perpendicularly from an opposing end with at least one primary slot; a central busbar having a central mounting plain extending perpendicularly from an end with at least one hole therethrough, mounted to the primary mounting plain, and a central slot therethrough on an opposing end; and an ancillary busbar mounted to the central busbar around the central slot and physically and electrically connected to a power providing unit.

In some embodiments, the backplane slot comprises an oval shape. In some embodiments, the primary slot comprises an oval shape. In some embodiments, the central slot comprises an oval shape. In some embodiments, the primary busbar includes a floating busbar configured to float relative to at least one of the backplane and the power providing unit. In some embodiments, the central busbar includes a floating busbar configured to float relative to the backplane and the power providing unit. In some embodiments, the ancillary busbar includes a floating busbar configured to float relative to the backplane and the power providing unit. In some embodiments, the ancillary busbar includes at least one mounting hole configured to receive a corresponding fastener that mounts the ancillary busbar to the centra busbar. In some embodiments, the power providing unit includes a transformer.

In some embodiments, a system for power distribution includes: a backplane having at least one backplane slot; a primary busbar mounted to the backplane and having a primary mounting plain extending perpendicularly with at least one slot, wherein the primary busbar includes a first floating busbar; a central busbar having at least one central slot and a central mounting plain extending perpendicularly with a hole, wherein the central busbar includes a second floating busbar; and an ancillary busbar mounted to the central busbar via the central slot and physically and electrically connected to a power providing unit.

In some embodiments, the backplane includes at least two backplane slots. In some embodiments, the central mounting plain includes at least two holes. In some embodiments, the central busbar includes at least two central slots. In some embodiments, the backplane slot comprises an oval shape. In some embodiments, the at least one slot primary busbar comprises an oval shape. In some embodiments, the central slot comprises an oval shape. In some embodiments, the primary busbar is configured to float relative to at least one of the backplane and the power providing unit. In some embodiments, the central busbar is configured to float relative to the backplane and the power providing unit. In some embodiments, the ancillary busbar includes a third floating busbar configured to float relative to the backplane and the power providing unit. In some embodiments, the ancillary busbar includes at least one mounting hole configured to receive a corresponding fastener that mounts the ancillary busbar to the centra busbar.

The embodiments have been described in the context of preferred and other embodiments and not every embodiment of has been described. Obvious modifications and alterations to the described embodiments are available to those of ordinary skill in the art having the benefits of the present disclosure. The disclosed and undisclosed embodiments are not intended to limit or restrict the scope or applicability of the embodiments conceived of by the Applicant, but rather, in conformity with the patent laws, Applicant intends to fully protect all such modifications and improvements that come within the scope or range of equivalents of the following claims.
The disclosure comprises the following items:
1. A power distribution unit comprising:
   a backplane having at least one backplane slot;
   a primary busbar mounted to the backplane, having a least one primary fastener hole on one end and a primary mounting plain extending perpendicularly from an opposing end with at least one primary slot;
   a central busbar having a central mounting plain extending perpendicularly from an end with at least one hole therethrough, mounted to the primary mounting plain, and a central slot therethrough on an opposing end; and
   an ancillary busbar mounted to the central busbar around the central slot and physically and electrically connected to a power providing unit.
2. The power distribution unit of to item 1, wherein the backplane slot comprises an oval shape.
3. The power distribution unit of item 1 or item 2, wherein the primary slot comprises an oval shape.
4. The power distribution unit of any preceding item, wherein the central slot comprises an oval shape.
5. The power distribution unit of any preceding item, wherein the primary busbar includes a floating busbar configured to float relative to at least one of the backplane and the power providing unit.
6. The power distribution unit of any preceding item, wherein the central busbar includes a floating busbar configured to float relative to the backplane and the power providing unit.
7. The power distribution unit of any preceding item, wherein the ancillary busbar includes a floating busbar configured to float relative to the backplane and the power providing unit.
8. The power distribution unit of any preceding item, wherein the ancillary busbar includes at least one mounting hole configured to receive a corresponding fastener that mounts the ancillary busbar to the centra busbar.
9. The power distribution unit of any preceding item, wherein the power providing unit includes a transformer.
10. A system for power distribution, the system comprising:
   a backplane having at least one backplane slot;
   a primary busbar mounted to the backplane and having a primary mounting plain extending perpendicularly with at least one slot, wherein the primary busbar includes a first floating busbar;
   a central busbar having at least one central slot and a central mounting plain extending perpendicularly with a hole, wherein the central busbar includes a second floating busbar; and
   an ancillary busbar mounted to the central busbar via the central slot and physically and electrically connected to a power providing unit.
11. The system of item 10, wherein the backplane includes at least two backplane slots.
12. The system of item 10 or item 11, wherein the central mounting plain includes at least two holes.
13. The system of any of items 10-12, wherein the central busbar includes at least two central slots.
14. The system of any of items 10-13, wherein the backplane slot comprises an oval shape.
15. The system of items 10-14, wherein the at least one slot primary busbar comprises an oval shape.
16. The system of items 10-15, wherein the central slot comprises an oval shape.
17. The system of items 10-16, wherein the primary busbar is configured to float relative to at least one of the backplane and the power providing unit.
18. The system of items 10-17, wherein the central busbar is configured to float relative to the backplane and the power providing unit.
19. The system of items 10-18, wherein the ancillary busbar includes a third floating busbar configured to float relative to the backplane and the power providing unit.
20. The system of items 10-19, wherein the ancillary busbar includes at least one mounting hole configured to receive a corresponding fastener that mounts the ancillary busbar to the centra busbar.

## Claims

1. A power distribution unit comprising:
a backplane having at least one backplane slot;
a primary busbar mounted to the backplane, having a least one primary fastener hole on one end and a primary mounting plain extending perpendicularly from an opposing end with at least one primary slot;
a central busbar having a central mounting plain extending perpendicularly from an end with at least one hole therethrough, mounted to the primary mounting plain, and a central slot therethrough on an opposing end; and
an ancillary busbar mounted to the central busbar around the central slot and physically and electrically connected to a power providing unit.

2. The power distribution unit of claim 1, wherein the backplane slot comprises an oval shape.

3. The power distribution unit of claim 1 or claim 2, wherein the primary slot comprises an oval shape.

4. The power distribution unit of any preceding claim, wherein the central slot comprises an oval shape.

5. The power distribution unit of any preceding claim, wherein the primary busbar includes a floating busbar configured to float relative to at least one of the backplane and the power providing unit.

6. The power distribution unit of any preceding claim, wherein the central busbar includes a floating busbar configured to float relative to the backplane and the power providing unit.

7. The power distribution unit of any preceding claim, wherein the ancillary busbar includes a floating busbar configured to float relative to the backplane and the power providing unit.

8. The power distribution unit of any preceding claim, wherein the ancillary busbar includes at least one mounting hole configured to receive a corresponding fastener that mounts the ancillary busbar to the central busbar.

9. The power distribution unit of any preceding claim, wherein the power providing unit includes a transformer.

10. The system of any preceding claim, wherein the backplane includes at least two backplane slots.

11. The system of any preceding claim, wherein the central mounting plain includes at least two holes.

12. The system of any preceding claim, wherein the central busbar includes at least two central slots.
